# EUROPEAN PATENT APPLICATION

(11) **EP 2 428 809 A2**
(43) Date of publication of application: **14.03.2012**
(21) Application number: 11177333.9
(22) Date of filing: 11.08.2011
(51) Int. Cl.: G01R 31/36

(54) **Battery controller and voltage abnormality detection method**

(30) Priority: 10.09.2010 JP 2010202628
(71) Applicant: HITACHI VEHICLE ENERGY, LTD., Hitachinaka-shi Ibaraki 312-0061 (JP)
(72) Inventor: Kawasaki, Tatsuhiko, Hitachinaka-shi, Ibaraki 312-0061 (JP); Hara, Kenji, Hitachinaka-shi, Ibaraki 312-0061 (JP); Nanto, Toshiyuki, Hitachinaka-shi, Ibaraki 312-0061 (JP); Takahashi, Hirofumi, Hitachinaka-shi, Ibaraki 312-0061 (JP)
(74) Representative: MERH-IP Matias Erny Reichl Hoffmann

(57) **Abstract**

A battery controller 40 for controlling an assembled battery configured by connecting battery groups each including battery cells, includes: voltage measuring units that are provided respectively for the battery groups each to measure a voltage of each of the battery cells included in a corresponding battery group; a minimum value detecting unit that detects a minimum value of the battery cells for each of the battery groups based upon the measured voltage of each of the battery cells; a reference value setting unit that sets a reference value used to determine an abnormal voltage drop for each of the battery groups based upon the measured voltage of each of the battery cells; and an abnormality determining unit that makes a determination that an abnormal voltage drop is present, if a difference between the reference value and the minimum value exceeds a predetermined value, for each of the battery groups.

## Description

The disclosure of the following priority application is herein incorporated by reference: Japanese Patent Application No. 2010-202628 filed September 10, 2010.

The present invention relates to a battery module configured by connecting a plurality of secondary batteries to be mounted on a vehicle or the like.

For reasons of issues on global warming and exhaustible fuels, electric vehicles (EVs) and hybrid electric vehicles (HEVs) in which part of drive is assisted by an electric motor have been developed by respective automobile manufacturers. Thus, there has been an increasing demand for a high-capacity, high-output secondary battery as a power source of the vehicles. As a power source consistent with such a demand, a high-voltage secondary battery is now a focus of attention.

Since a vehicular secondary battery carries a large amount of electric current, a micro-short circuit due to the mixing of foreign matter incurs reliability degradation or an increase in time degradation. The secondary battery has a structure in which a separator serving as an insulator is included between a positive electrode and a negative electrode. If any electrically-conductive foreign matter (for example, a metal piece) gets mixed between one of these electrodes and the separator, the positive and negative electrodes suffer a micro-short circuit, thus causing an abnormal voltage drop in the secondary battery.

As one of techniques to detect an abnormal voltage drop in the secondary battery, there is mentioned the technique described in Japanese Laid-Open Patent Publication No. 2002-10511. This technique detects a secondary battery having suffered an abnormal voltage drop on the basis of the average voltage values of secondary batteries in a specific module.

In Japanese Laid-Open Patent Publication No. 2002-10511, an average voltage value of secondary batteries in the specific module is used as a common reference value among a plurality of modules. However, if any abnormality is present in a voltage measuring unit (cell controller IC) itself for detecting the voltage of a cell controller in the specific module, it is not possible to precisely detect the abnormal voltage drop in the secondary battery.

That is, there has been the problem that if any abnormality is present in the cell controller itself due to effects of voltage variation caused by an individual difference or a temperature change, an erroneous determination is made that an abnormal voltage drop has occurred in a secondary battery which is not abnormal.

According to the 1 st aspect of the present invention, a battery controller for controlling an assembled battery configured by connecting a plurality of battery groups each including a plurality of battery cells, comprises: a plurality of voltage measuring units that are provided respectively for the plurality of battery groups each to measure a voltage of each of the battery cells included in a corresponding battery group; a minimum value detecting unit that detects a minimum value of the battery cells for each of the plurality of battery groups based upon the voltage of each of the battery cells measured by a corresponding voltage measuring unit; a reference value setting unit that sets a reference value used to determine an abnormal voltage drop for each of the plurality of battery groups based upon the voltage of each of the battery cells measured by the corresponding voltage measuring unit; and/or an abnormality determining unit that makes a determination that an abnormal voltage drop is present, if a difference between the reference value and the minimum value exceeds a predetermined value, for each of the plurality of battery groups.

According to the 2nd aspect of the present invention, in the battery controller according to the 1st aspect, it is preferred that the reference value setting unit sets a maximum voltage of the battery cells within a battery group as the reference value.

According to the 3rd aspect of the present invention, in the battery controller according to the 1st aspect, it is preferred that the reference value setting unit sets an average voltage value of battery cells except a battery cell having a minimum voltage, within a battery group as the reference value.

According to the 4th aspect of the present invention, in the battery controller according to the 1st aspect, it is preferred that the reference value setting unit sets a median voltage value of battery cells except a battery cell having a minimum voltage, within a battery group as the reference value.

According to the 5th aspect of the present invention, in the battery controller according to the 1st aspect, it is preferred that the battery controller further comprises: a temperature measuring unit that measures a temperature of each of the plurality of voltage measuring units; and a reference value changing unit that changes the reference value based upon the temperature measured by the temperature measuring unit.

According to the 6th aspect of the present invention, in the battery controller according to the 1st aspect, it is preferred that the battery controller further comprises: a stop time measuring unit that measures a time during which a vehicle mounted with the assembled battery is stopped; and a reference value changing unit that changes the reference value based upon the stop time measured by the stop time measuring unit.

According to the 7th aspect of the present invention, in the battery controller according to the 1st aspect, it is preferred that the battery controller further comprises: a typical value calculating unit that calculates an average value or a median value of voltages of the battery cells as a typical value for each of the plurality of battery groups based upon the voltage of each of the battery cells measured by the corresponding voltage measuring unit; a typical reference value calculating unit that calculates an average value or a median value of typical values of the battery groups calculated by the typical value calculating unit as a typical reference value used to determine an abnormality in the voltage measuring units; and a second abnormality determining unit that makes a determination, for each of the plurality of battery groups, that an abnormality is present in a voltage measuring unit, if a difference between the typical value and the typical reference value exceeds a predetermined value.

According to the 8th aspect of the present invention, in the battery controller according to the 1 st aspect, it is preferred that the battery controller further comprises: a first control unit; and a second control unit connected to the first control unit through a communication line, wherein: the first control unit includes the plurality of voltage measuring units; and the second control unit includes the minimum value detecting unit, the reference value setting unit and the abnormality determining unit and configured to receive voltages of the plurality of battery cells measured by the plurality of voltage measuring units of the first control unit.

According to the 9th aspect of the present invention, in the battery controller according to the 8th aspect, it is preferred that the reference value setting unit sets a maximum voltage of the battery cells within a battery group as the reference value.

According to the 10th aspect of the present invention, in the battery controller according to the 8th aspect, it is preferred that the reference value setting unit sets an average voltage of the battery cells except a battery cell having a minimum voltage, within a battery group as the reference value.

According to the 11th aspect of the present invention, in the battery controller according to the 8th aspect, it is preferred that the reference value setting unit sets a median voltage value of the battery cells except a battery cell having a minimum voltage, within a battery group as the reference value.

According to the 12th aspect of the present invention, in the battery controller according to the 8th aspect, it is preferred that the second control unit includes: a temperature measuring unit that measures a temperature of each of the plurality of voltage measuring units; and a reference value changing unit that changes the reference value based upon the temperature measured by the temperature measuring unit.

According to the 13th aspect of the present invention, a method for detecting an abnormal voltage in an assembled battery configured by connecting a plurality of battery groups each including a plurality of battery cells, comprises: a voltage measuring step of measuring a voltage of each of the battery cells included in each of the plurality of battery groups; a minimum value detecting step of detecting a minimum value of the battery cells for each of the plurality of battery groups based upon the voltage of each of the battery cells measured in the voltage measuring step; a reference value setting step of setting a reference value used to determine an abnormal voltage drop for each of the plurality of battery groups based upon the voltage of each of the battery cells measured in the voltage measuring step; and an abnormality determining step of making a determination that an abnormal voltage drop is present, if a difference between the reference value and the minimum value exceeds a predetermined value, for each of the plurality of battery groups.

According to the 14th aspect of the present invention, in the method for detecting an abnormal voltage in an assembled battery according to the 13th aspect, it is preferred that: a first control unit of the assembled battery executes the voltage measuring step; and a second control unit connected to the first control unit of the assembled battery through a communication line receives voltages of the plurality of battery cells measured by the voltage measuring step of the first control unit and executes the minimum value detecting step, the reference value setting step and the abnormality determining step.

### BRIEF DESCRIPTION OF THE DRAWINGS

FIG 1 is an exploded perspective view illustrating a structure of a cylindrical secondary battery;
FIG 2 is a cross-sectional view illustrating the structure of the cylindrical secondary battery;
FIG 3 is a conceptual view illustrating a battery module structure of the present invention;
FIG 4 is a flowchart (1) used to make an abnormality determination on a secondary battery of the present invention;
FIG 5 is a flowchart (2) used to make an abnormality determination on a secondary battery of the present invention;
FIG 6 is a flowchart used to make an abnormality determination on a secondary battery of the present invention according to the temperature of a cell controller;
FIG 7 is a flowchart used to make an abnormality determination on a secondary battery of the present invention according to a stop time; and
FIG 8 is a flowchart used to make an abnormality determination on a cell controller IC of the present invention.

### DESCRIPTION OF PREFERRED EMBODIMENTS

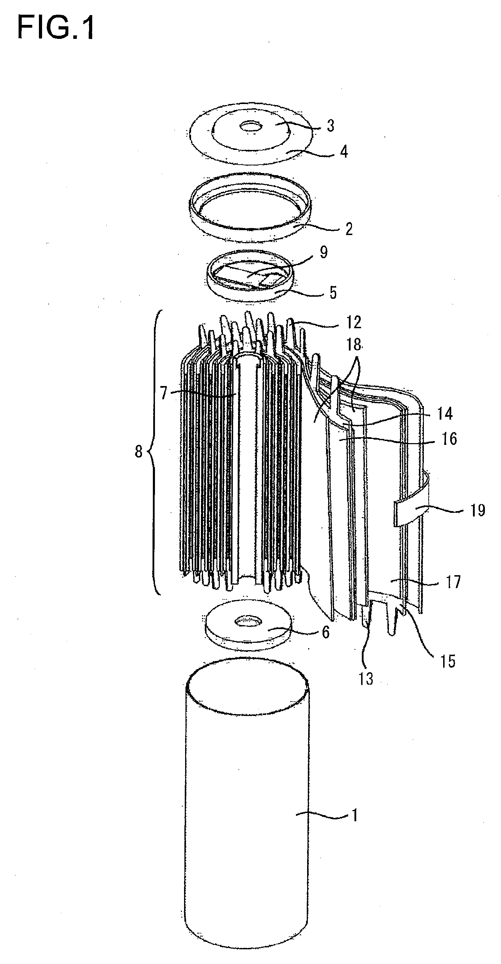

Hereinafter, embodiments for carrying out the present invention will be described according to FIGS. 1 to 8.

FIG 1 is an exploded perspective view illustrating a structure of a cylindrical lithium-ion secondary battery which is one of vehicular secondary batteries. A positive electrode 14 is a thin film of metal, such as aluminum, on both sides of which a positive electrode mixture 16 is coated. In the figure, a plurality of positive electrode tabs 12 is provided on an upper long side. A negative electrode 15 is a thin film of metal, such as copper, on both sides of which a negative electrode mixture 17 is coated. In the figure, a plurality of negative electrode tabs 13 is provided on a lower long side.

These positive electrode 14 and negative electrode 15 are wound around a resin winding core 7 through a porous insulating separator 18. An outermost-circumferential separator is fastened with a tape 19 to configure an electrode group 8. Note that the electrode group 8 can be configured no matter whether the direction of winding is clockwise or counterclockwise.

A positive electrode current collecting plate (positive electrode current collecting component) 5 and a negative electrode current collecting plate (negative electrode current collecting component) 6 are respectively fixed to the two ends of the tubular winding core 7 by means of mutual fitting. The positive electrode tabs 12 are welded to the positive electrode current collecting component 5 by, for example, an ultrasonic welding method. Likewise, the negative electrode tabs 13 are welded to the negative electrode current collecting component 6 by, for example, an ultrasonic welding method. The electrode group 8 wound around the resin winding core 7 is housed in a battery cell container (battery case) 1 also serving as a negative electrode terminal, with the positive electrode current collecting plate 5 and the negative electrode current collecting plate 6 attached to the electrode group. At this time, the negative electrode current collecting plate 6 is electrically connected to the battery cell container 1 through a negative lead (not illustrated). Thereafter, a non-aqueous electrolyte is injected into the battery cell container 1. In addition, a gasket 2 is provided between the battery cell container 1 and a top cover case 4. With this gasket 2, an opening of the battery cell container 1 is sealed and the battery cell container is electrically isolated. A conductive top cover unit provided so as to seal an opening of the battery cell container 1 is located on the positive electrode current collecting plate 5. The top cover unit includes a top cover 3 and the top cover case 4. One end of a positive lead 9 is welded to the top cover case 4 and the other end thereof is welded to the positive electrode current collecting component 5, thereby electrically connecting the top cover unit to a positive electrode of the electrode group 8.

The positive electrode mixture 16 includes an active positive electrode material, an electrically conductive positive electrode material, and a positive electrode binder. The active positive electrode material is preferably a lithium oxide. Examples of the lithium oxide include lithium cobaltate, lithium manganate, lithium nickelate, iron lithium phosphate, and lithium composite oxides (lithium oxides composed of two or more types of materials selected from the group consisting of cobalt, nickel and manganese). There is no limitation on the electrically conductive positive electrode material, as long as the material is a substance capable of facilitating the transfer of electrons produced by the occlusion/emission reaction of lithium ions in the positive electrode mixture to the positive electrode. Examples of the electrically conductive positive electrode material include graphite and acetylene black. The positive electrode binder is not limited in particular, as long as the binder can bind the active positive electrode material and the electrically conductive positive electrode material, and the positive electrode mixture and the positive electrode collector, and does not deteriorate significantly through contact with the non-aqueous electrolyte. Examples of the positive electrode binder include polyvinylidene fluoride (PVDF) and fluorine-containing rubber. A method for forming the positive electrode mixture is not limited, as long as the positive electrode mixture is formed on the positive electrode. As a method for forming the positive electrode mixture, there can be mentioned a method for coating a dispersion liquid composed of the constitutive substances of the positive electrode mixture onto the positive electrode. Examples of coating methods include a roll coating method and a slit die coating method. Examples of solvents to be used for the dispersion liquid include N-methylpyrrolidone (NMP) and water. One example of the coating thickness of the positive electrode mixture 16 is approximately 40 µm on one side.

The negative electrode mixture 17 includes an active negative electrode material, a negative electrode binder, and a thickener. Note that the negative electrode mixture 17 may include an electrically conductive negative electrode material, such as acetylene black. In the present invention, graphite carbon is preferably used as the active negative electrode material. Use of graphite carbon enables the fabrication of a lithium-ion secondary battery cell for use in a plug-in hybrid vehicle and an electric vehicle requiring high capacity. A method for forming the negative electrode mixture 17 is not limited, as long as the negative electrode mixture 17 is formed on the negative electrode 15. As a method for forming the negative electrode mixture 17, there can be mentioned a method for coating a dispersion liquid composed of the constitutive substances of the negative electrode mixture 17 onto the negative electrode 15. Examples of coating methods include a roll coating method and a slit die coating method. One example of the coating thickness of the negative electrode mixture 17 is approximately 40 µm on one side.

As the non-aqueous electrolyte, it is preferable to use a solution composed of a carbonate-based solvent in which lithium salt is dissolved. Examples of the lithium salt include lithium fluorophosphate (LiPF₆) and lithium fluoborate (LiBF₆). In addition, examples of the carbonate-based solvent include ethylene carbonate (EC), dimethyl carbonate (DMC), propylene carbonate (PC), methylethyl carbonate (MEC), and any one of the abovementioned solvents mixed with one or more than one type of solvent selected from the group consisting of the abovementioned solvents.

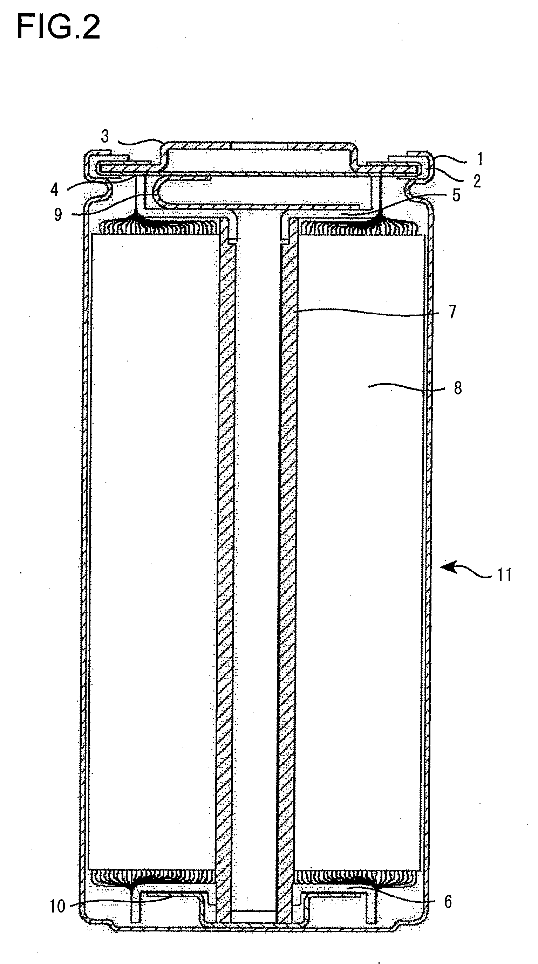

FIG 2 illustrates a schematic cross-sectional view of the cylindrical battery. The electrode group 8 wound around the resin winding core 7 is fitted with the positive electrode current collecting plate 5 and the negative electrode current collecting plate 6 and is housed in the battery cell container 1. Of the electrode group 8, the negative-polarity electrodes are connected to the negative electrode current collecting plate 6 by means of welding or the like, and are electrically connected to the battery cell container 1 through negative leads 10.

After the electrode group 8, the positive electrode current collecting plate 5, and the negative electrode current collecting plate 6 are housed in the battery cell container 1, a welding jig is led through the central opening of the winding core 7 to weld the bottom of the battery cell container 1 and the negative leads 10 to each other. Thereafter, an electrolyte is injected into the battery cell container 1. The conductive top cover unit provided so as to seal the opening of the battery cell container 1 is located on the positive electrode current collecting plate 5. The top cover unit includes the top cover 3 and the top cover case 4. One end of the positive lead 9 is welded to the top cover case 4 and the other end thereof is welded to the positive electrode current collecting component 5, thereby electrically connecting the top cover unit and the positive electrode of the electrode group 8 to each other. The gasket 2 is provided between the battery cell container 1 and the top cover case 4. With this gasket 2, the opening of the battery cell container 1 is sealed and the battery cell container 1 and the top cover case 4 are electrically isolated from each other. Consequently, a secondary battery 11 is configured.

There is the possibility of electrically conductive foreign matter getting mixed in the secondary battery 11 thus fabricated. The foreign matter may be contained in a raw material or may derive from dust generated from apparatus in a production phase or from machining swarf or the like generated by welding or cutting. If this foreign matter becomes caught between an electrode and a separator 18, the positive electrode 14 and the negative electrode 15 become micro-short-circuited through the foreign matter. Thus the voltage of the secondary battery 11 drops. Hence, aging is performed in order to detect whether or not a micro-short circuit is present in the secondary battery 11. When the secondary battery 11 is subjected to aging, the voltage thereof gently drops due to self-discharge if the battery is normal. In contrast, if the secondary battery is micro-short-circuited, a voltage drop due to the short circuit is superimposed on the voltage drop of the secondary battery. Consequently, the amount of voltage drop in the secondary battery becomes larger than that in a normal secondary battery. Accordingly, the amount of voltage drop in the secondary battery 11 is measured before and after aging. If the voltage drop exceeds a predetermined value, the secondary battery 11 is detected as a micro-short-circuited secondary battery.

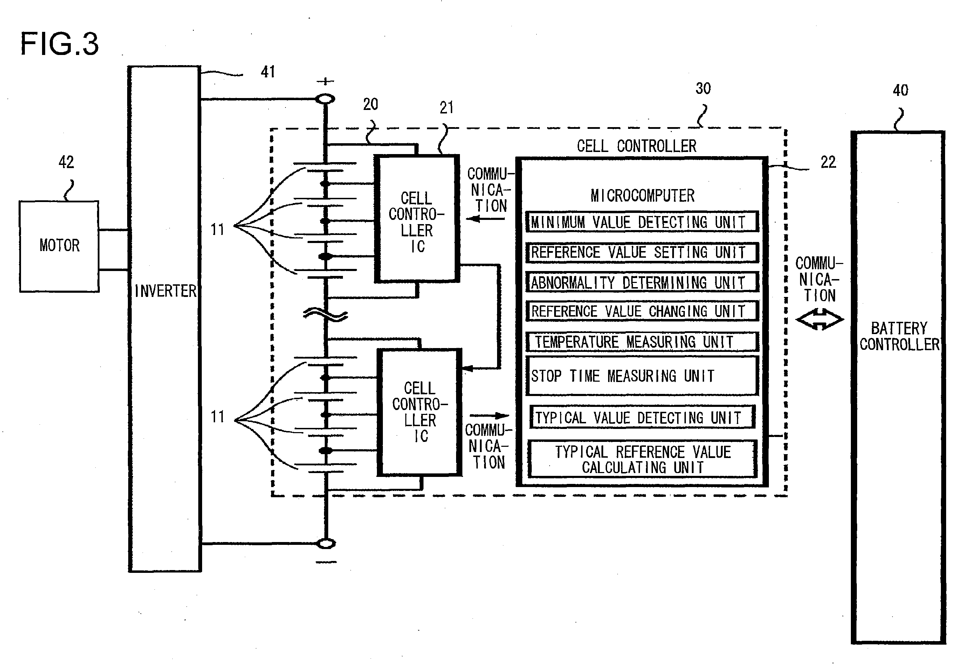

FIG 3 illustrates a configuration of a battery module according to the present invention. An assembled battery 20 is configured in the manner that a plurality of secondary batteries 11 is connected in series, and both terminals of each secondary battery 11 are electrically connected to a cell controller IC 21. Each cell controller IC 21 includes an unillustrated cell voltage detecting circuit to detect the no-load voltage of each secondary battery 11. The cell controller IC 21 is also referred to as a voltage measuring unit. In addition, a group including a plurality of unit cells (battery cells) connected by way of one cell controller IC 21 is referred to as a battery group.

A cell controller 30 is configured in the manner that a plurality of these assembled batteries 20 is arranged and electrically connected in series with a microcomputer 22. Here, the term "no-load" refers to a state in which a load, such as a motor, is not connected, and does not include states in which any circuit loads, such as cell controller ICs 21, are connected. Each cell controller IC 21 is connected to the microcomputer 22 through a communication line. The microcomputer 22 controls various types of information, including charge/discharge information on the assembled batteries 20. A plurality of cell controllers 30 is electrically connected to a battery controller 40. The battery controller 40 manages the control of and information on each cell controller 30 through a communication line, and communicates with a host system, such as a vehicle. Note that in the present invention, the cell controller 30 and the battery controller 40 may also be referred to as battery controllers.

In addition, the secondary batteries 11 are electrically connected to an inverter 41 for inverting DC power to three-phase AC power through positive terminals and negative terminals. Furthermore, this inverter 41 is electrically connected to a motor 42 for driving a vehicle.

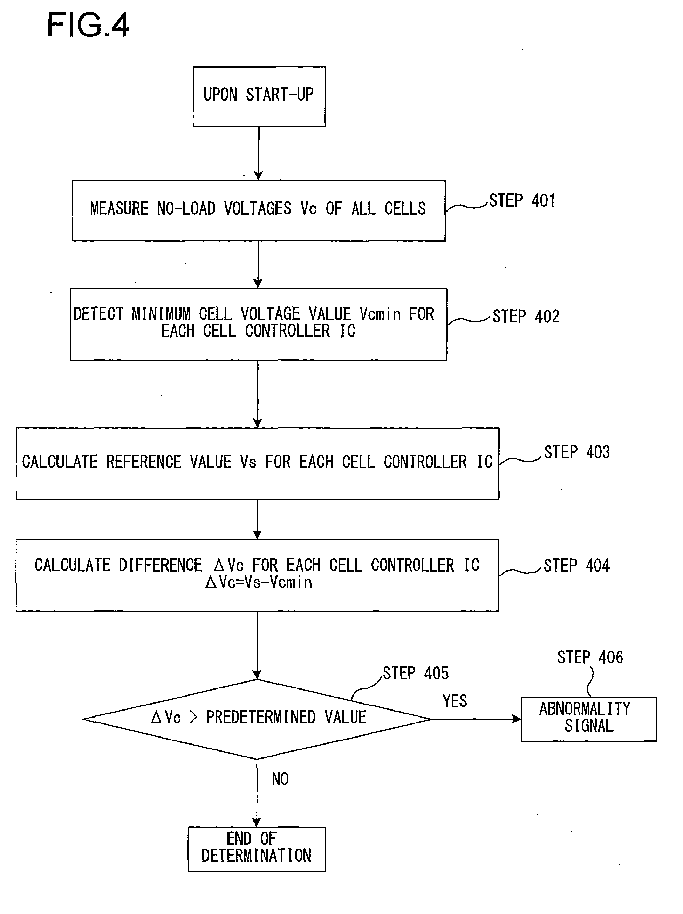

The microcomputer 22 includes a minimum value detecting unit, a reference value setting unit, a warning unit, a reference value changing unit, a typical value detecting unit, and a typical reference value calculating unit used to execute processes to be described later in FIGS. 4 to 8. Note that the minimum value detecting unit, the reference value setting unit, an abnormality determining unit (warning unit), the reference value changing unit, a temperature measuring unit, a stop time measuring unit, the typical value detecting unit, and the typical reference value calculating unit may be included in the battery controller 40, rather than in the microcomputer 22, to execute the processes therein.

An abnormal voltage drop may occur also in the secondary batteries 11 mounted on the battery module. The cause for this is assumed to be that some sort of stress is applied to within the battery case by external impact, such as vibration, at the time of module manufacturing or after mounting on a vehicle or by the charge/discharge of a secondary battery and, consequently, foreign matter floating within a secondary battery 11 causes a micro-short circuit between the positive electrode 14 and the negative electrode 15.

FIG 4 illustrates a flow of determination used to detect an abnormal voltage drop in a secondary battery 11 within the battery module. A control unit of the microcomputer 22 plays a major role in carrying out the below-described steps of determination.

At the time of start-up, the microcomputer 22 sends an instruction to measure a cell voltage to each cell controller IC 21. Upon receipt of the instruction from the microcomputer 22, each cell controller IC 21 measures the no-load voltage (cell voltage) Vc of each secondary battery 11 which the cell controller IC controls (step 401), and transmits the measured no-load voltage Vc to the microcomputer 22. Note that here, the cell controller IC 21 has begun to measure a cell voltage according to the cell voltage measurement instruction from the microcomputer 22. However, without limitation to this configuration, the battery module may be configured so that the cell controller IC 21 automatically measures a cell voltage even in the absence of the abovementioned instruction.

Next, each microcomputer 22 evaluates the minimum cell voltage value Vcmin of each cell controller IC 21 on the basis of the measured no-load voltage (cell voltage) Vc of each of the secondary batteries 11 (step 402, processing by the minimum value detecting unit). In addition, each microcomputer 22 sets a reference value Vs for each cell controller IC 21 on the basis of the detected no-load voltage (cell voltage) Vc of each of the secondary batteries 11 (step 403, processing by the reference value setting unit). A method for setting the reference value will be described later.

Thereafter, each microcomputer 22 calculates a difference ΔVc between the acquired reference value Vs and the minimum cell voltage value Vcmin (step 404).

In addition, each microcomputer 22 determines whether or not the difference ΔVc between the reference value Vs and the minimum cell voltage value Vcmin is larger than a previously specified value (predetermined value) (step 405, processing by the abnormality determining unit).

If at this time, ΔVc is larger than the predetermined value, the microcomputer 22 determines that an abnormal voltage drop has occurred in the secondary battery 11 in which the minimum cell voltage value Vcmin has been detected, and sends out an abnormality signal (alarm) to the battery controller 40 (step 406).

On the other hand, if ΔVc is smaller than the predetermined value, no problems are posed and processing is completed.

Here, it is assumed that a plurality of predetermined values can be set. Thus, an alarm level may be varied in such a manner as caution, and then warning, and then stop, each time the predetermined value is incremented. As an alternative method, the standard deviation σ of each cell voltage detected for each cell controller IC 21 may be evaluated and a value n times the standard deviation σ may be set as the predetermined value. At this time, the standard deviation σ may be calculated with the minimum cell voltage value Vcmin excluded.

In addition, the reference value is preferably a cell voltage when a secondary battery 11 undergoes a voltage drop due only to self-discharge. However, the amount of self-discharge varies according to the production tolerance of each secondary battery 11 or an aging period, and therefore, it is difficult to set the reference value to any fixed value. Hence, a method is available in which secondary batteries within the same cell controller IC are treated as comparative levels. For example, by defining the reference value with a maximum value among cell voltages within the same cell controller IC, it is possible to compare the amounts of voltage drop in respective secondary batteries on the basis of the cell voltage of a secondary battery whose amount of self-discharge is assumed to be minimum. In addition, by defining the reference value with an average value or a median value of respective cell voltages, except the minimum value thereof, within the same cell controller IC, it is possible to compare the amounts of voltage drop in respective secondary batteries on the basis of the cell voltage of a secondary battery whose amount of self-discharge is assumed to be typical.

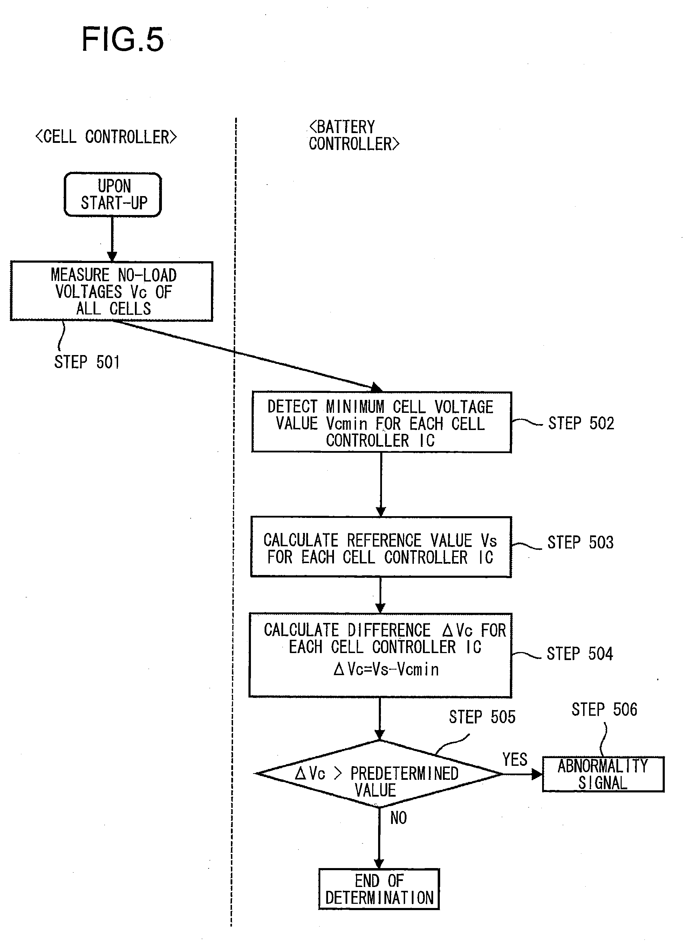

FIG 5 illustrates another flow of determination used to detect an abnormal voltage drop in each secondary battery 11 within the battery module. The basics of the flow are the same as those of the flow in FIG 4. The flow differs, however, in that a control unit of the battery controller 40 plays a major role in carrying out processing after voltage measurement.

At the time of start-up, the battery controller 40 sends an instruction to measure a cell voltage to each cell controller IC 21 through the microcomputer 22. Upon receipt of the instruction from the battery controller 40, each cell controller IC 21 measures the no-load voltage (cell voltage) Vc of each of the secondary batteries 11 which the cell controller IC controls (step 501), and sends the measured no-load voltages Vc to the battery controller 40 through the microcomputer 22. Note that here, the cell controller IC 21 has begun to measure a cell voltage according to the cell voltage measurement instruction from the battery controller 40. However, without limitation to this configuration, the battery module may be configured so that the cell controller IC 21 automatically measures a cell voltage even in the absence of the abovementioned instruction.

Next, the battery controller 40 evaluates a minimum value Vcmin of cell voltages for each cell controller IC 21 on the basis of the measured no-load voltage (cell voltage) Vc of each of the secondary batteries 11 (step 502, processing by a minimum value detecting unit). In addition, the battery controller 40 calculates a reference value Vs from respective cell voltages for each cell controller IC 21 on the basis of the detected no-load voltage (cell voltage) Vc of each of the secondary batteries 11 (step 503, processing by a reference value setting unit). A method for calculating the reference value will be described later.

Thereafter, the battery controller 40 calculates a difference ΔVc between the acquired reference value Vs for each cell controller IC 21 and the minimum cell voltage value Vcmin (step 504). In addition, the battery controller 40 determines whether or not the difference ΔVc between the reference value Vs and the minimum cell voltage value Vcmin is larger than a previously specified value (predetermined value) (step 505, processing by an abnormality determining unit).

If at this time, ΔVc is larger than the predetermined value, the battery controller 40 determines that an abnormal voltage drop has occurred in the secondary battery 11 in which the minimum cell voltage value Vcmin has been detected, and sends out an abnormality signal (alarm) (step 506).

On the other hand, if ΔVc is smaller than the predetermined value, no problems are posed and processing is completed.

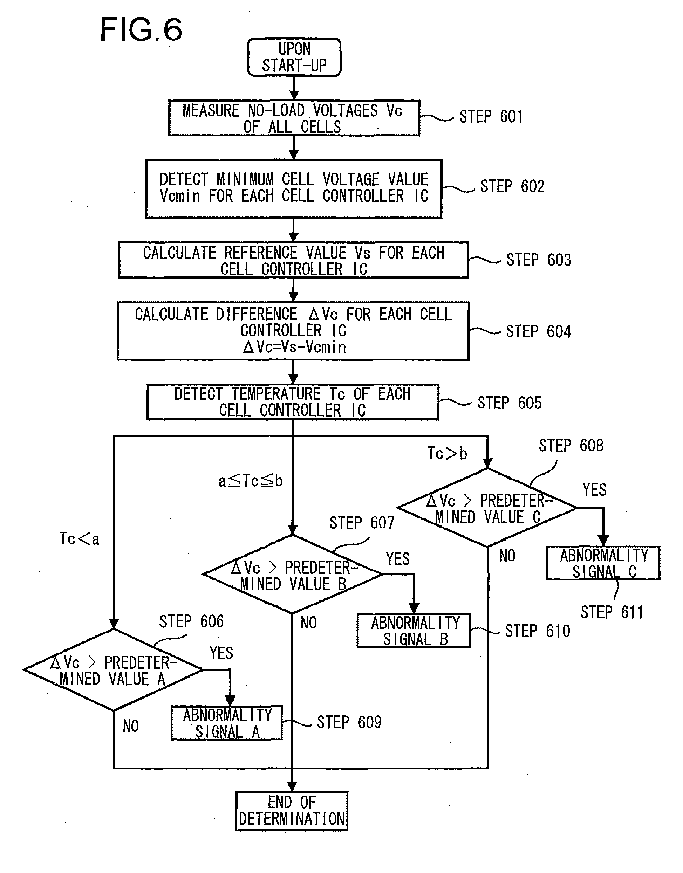

As an application example of the present invention, FIG 6 illustrates a flow of determination used to detect an abnormal voltage drop in secondary batteries 11 within the battery module according to the temperature of each cell controller IC. The detected voltage of each cell controller IC varies widely, depending particularly on temperature. Accordingly, higher-accuracy abnormality determination is possible by changing the predetermined value according to temperature. In steps 601 up to 604, the same processing as in steps 401 to 404 of FIG 4 is carried out.

Each cell controller IC 21 includes therein a circuit for detecting the temperature thereof to detect cell controller IC temperature Tc when a flow of determination is put in operation (step 605, processing by a temperature measuring unit).

If the cell controller IC temperature Tc is lower than a, a determination is made using a predetermined value A (step 606, processing by an abnormality determining unit). If Tc is *a* or higher but not higher than b, a determination is made using a predetermined value B (step 607, processing by the abnormality determining unit). Likewise, if Tc is higher than b, a determination is made using a predetermined value C (step 608, processing by the abnormality determining unit). The type of abnormality signal may be changed according to a temperature level.

For example, if an abnormality signal A or an abnormality signal C is sent out in cases where Tc is lower than a or higher than b and determined to be abnormal, the signal may be defined as a warning level (at which a vehicle is allowed to run for a certain length of time or over a certain distance, and then brought to an emergency stop). Alternatively, if an abnormality signal B is sent out in cases where Tc is *a* or higher but not higher than b and determined to be abnormal, the vehicle may be brought to an emergency stop. Thus, an action to be taken can be selected optionally on the battery controller side according to the abnormality signal.

In step 606, if ΔVc is larger than the predetermined value A, a determination is made that an abnormal voltage drop has occurred in the secondary battery 11 in which the minimum cell voltage value Vcmin has been detected. Thus, an abnormality signal A (alarm A) is sent out to the battery controller 40 (step 609). On the other hand, if ΔVc is smaller than the predetermined value A, no problems are posed and processing is completed.

In step 607, if ΔVc is larger than the predetermined value B, a determination is made that an abnormal voltage drop has occurred in the secondary battery 11 in which the minimum cell voltage value Vcmin has been detected. Thus, an abnormality signal B (alarm B) is sent out to the battery controller 40 (step 610). On the other hand, if ΔVc is smaller than the predetermined value B, no problems are posed and processing is completed.

In step 608, if ΔVc is larger than the predetermined value C, a determination is made that an abnormal voltage drop has occurred in the secondary battery 11 in which the minimum cell voltage value Vcmin has been detected. Thus, an abnormality signal C (alarm C) is sent out to the battery controller 40 (step 611). On the other hand, if ΔVc is smaller than the predetermined value C, no problems are posed and processing is completed.

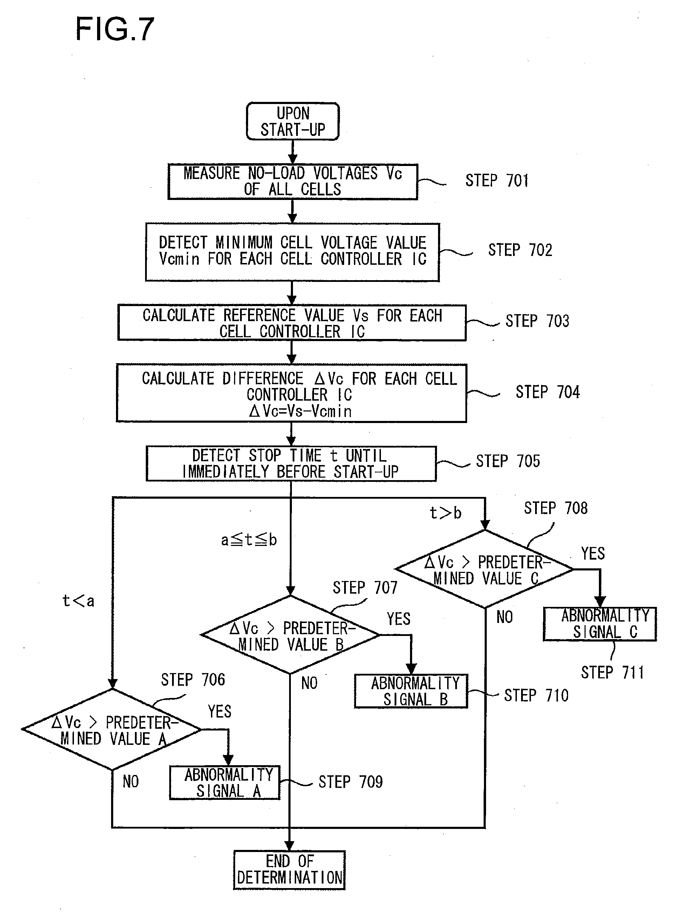

As an application example of the present invention, FIG 7 illustrates a flow of determination used to detect an abnormal voltage drop in secondary batteries 11 within the battery module at the time of start-up according to a stop time until immediately before the start-up. In steps 701 up to 704, the same processing as in steps 401 to 404 of FIG 4 is carried out.

A timer capable of measuring a period of time during which a system (i.e. a vehicle on which secondary batteries 11 are mounted) is stop is provided within the battery controller 40 to detect, at the time of start-up, a stop time t until immediately before the start-up (step 705, processing by a stop time measuring unit). If the stop time t is shorter than *a*, a determination is made using a predetermined value A (step 706, processing by an abnormality determining unit). If *t* is *a* or larger but not larger than b, a determination is made using a predetermined value B (step 707, processing by the abnormality determining unit). Likewise, if t is larger than b, a determination is made using a predetermined value C (step 708, processing by the abnormality determining unit). In the current battery module, the cell voltage is kept almost constant by a capacity-adjusting function at the time of charge/discharge. If a micro-short circuit occurs, the cell voltage drops according to the scale of the short-circuit and the stop time. Accordingly, by changing a value for the determination according to the stop time, it is possible to precisely detect a secondary battery in which an abnormal voltage drop has occurred. A stop of a vehicle means that a power for driving is turned off at the vehicle and a system including charging and discharging at a secondary battery mounted in the vehicle is stopped and shut down.

In step 706, if ΔVc is larger than the predetermined value A, a determination is made that an abnormal voltage drop has occurred in the secondary battery 11 in which the minimum cell voltage value Vcmin has been detected. Thus, an abnormality signal A (alarm A) is sent out to the battery controller 40 (step 709). On the other hand, if ΔVc is smaller than the predetermined value A, no problems are posed and processing is completed.

In step 707, if ΔVc is larger than the predetermined value B, a determination is made that an abnormal voltage drop has occurred in the secondary battery 11 in which the minimum cell voltage value Vcmin has been detected. Thus, an abnormality signal B (alarm B) is sent out to the battery controller 40 (step 710). On the other hand, if ΔVc is smaller than the predetermined value B, no problems are posed and processing is completed.

In step 708, if ΔVc is larger than the predetermined value C, a determination is made that an abnormal voltage drop has occurred in the secondary battery 11 in which the minimum cell voltage value Vcmin has been detected. Thus, an abnormality signal C (alarm C) is sent out to the battery controller 40 (step 711). On the other hand, if ΔVc is smaller than the predetermined value C, no problems are posed and processing is completed.

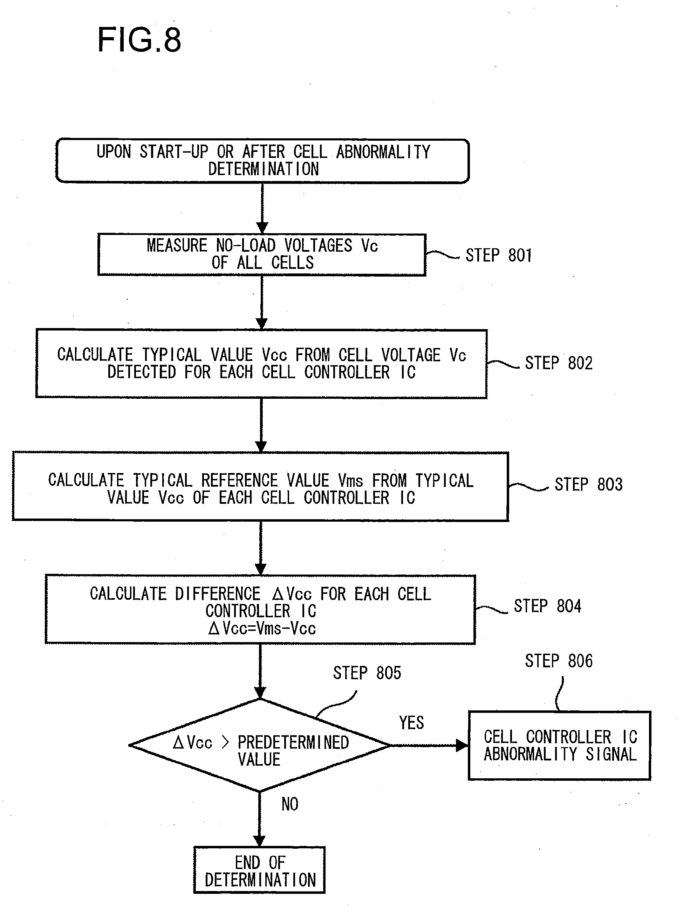

FIG 8 illustrates a flow of determination used to detect a voltage detection failure in a cell controller IC 21. When a determination is made with regard to an abnormal voltage drop in secondary batteries 11, it is a prerequisite that the cell controller IC 21 correctly detects a cell voltage. For this reason, a flow of determination illustrated in FIG 8 is carried out either before or after the flow of determination on an abnormal voltage drop made in FIGS. 4 to 7. By making a determination on a voltage detection failure in each cell controller IC 21 before the flow of determination on an abnormal voltage drop in each secondary battery 11, it is possible to previously assure that a determination on the abnormal voltage drop of the secondary battery 11 can be made correctly. In addition, by carrying out a determination on a voltage detection failure in a cell controller IC 21 after the flow of determination on an abnormal voltage drop in each secondary battery 11, it is possible to assure in an ex-post manner that a determination on an abnormal voltage drop in the secondary battery 11 has been made correctly.

In cases where a secondary battery 11 is used in, for example, a cold district, failures are liable to occur in a cell controller IC 21. Accordingly, the flow of determination in FIG 8 is intended to periodically verify whether or not this cell controller IC 21 operates normally.

At the time of start-up, the microcomputer 22 sends an instruction to measure a cell voltage to each cell controller IC 21. Upon receipt of the instruction from the microcomputer 22, the cell controller IC 21 measures the no-load voltage (cell voltage) Vc of each secondary battery 11 which the cell controller IC controls (step 801), and transmits the measured no-load voltage Vc to the microcomputer 22. Note that here, the cell controller IC 21 has begun to measure a cell voltage according to the cell voltage measurement instruction from the microcomputer 22. However, without limitation to this configuration, the battery module may be configured so that the cell controller IC 21 automatically measures a cell voltage even in the absence of the abovementioned instruction.

Next, the microcomputer 22 evaluates a typical value Vcc of cell voltages for each cell controller IC 21 on the basis of the measured no-load voltage (cell voltage) Vc of each of the secondary batteries 11 (step 802, processing by a typical value calculation unit). The typical value is calculated using an average value or a median value of detected respective cell voltages. At that time, the typical value may be calculated with the minimum value of the respective cell voltages excluded. In addition, the microcomputer 22 calculates a typical reference value Vms within the cell controller from the typical value of each of the cell controller ICs (step 803, processing by a typical reference value calculating unit). The typical reference value is calculated using an average value or a median value of typical values Vcc of respective cell controller ICs. At that time, the typical reference value may be calculated with the minimum value of the typical values Vcc of the respective cell controller ICs excluded.

Thereafter, the microcomputer 22 calculates a difference ΔVcc between the typical value Vcc of the cell controller IC and the typical reference value Vms within the cell controller (step 804).

In addition, the microcomputer 22 determines whether or not the difference ΔVcc between the typical value Vcc of the cell controller IC and the typical reference value Vms within the cell controller is larger than a previously specified value (predetermined value) (step 805).

If at this time, ΔVcc is larger than the predetermined value, the microcomputer 22 determines that a voltage detection failure has occurred in the cell controller IC, and sends out an abnormality signal (alarm) (step 806).

On the other hand, if ΔVcc is smaller than the predetermined value, no problems are posed and processing is completed.

As has been described heretofore, according to the battery module of the present embodiment, it is possible to precisely detect an abnormal voltage drop in a secondary battery without being affected by a voltage variation due to a individual difference or a temperature change in a voltage measuring unit (for example, a cell controller IC).

The above described embodiments are examples, and various modifications can be made without departing from the scope of the invention.

## Claims

1. A battery controller for controlling an assembled battery configured by connecting a plurality of battery groups each including a plurality of battery cells, comprising:
a plurality of voltage measuring units that are provided respectively for the plurality of battery groups each to measure a voltage of each of the battery cells included in a corresponding battery group;
a minimum value detecting unit that detects a minimum value of the battery cells for each of the plurality of battery groups based upon the voltage of each of the battery cells measured by a corresponding voltage measuring unit;
a reference value setting unit that sets a reference value used to determine an abnormal voltage drop for each of the plurality of battery groups based upon the voltage of each of the battery cells measured by the corresponding voltage measuring unit; and
an abnormality determining unit that makes a determination that an abnormal voltage drop is present, if a difference between the reference value and the minimum value exceeds a predetermined value, for each of the plurality of battery groups.

2. The battery controller according to claim 1, wherein:
the reference value setting unit sets a maximum voltage of the battery cells within a battery group as the reference value.

3. The battery controller according to claim 1, wherein:
the reference value setting unit sets an average voltage value of battery cells except a battery cell having a minimum voltage, within a battery group as the reference value.

4. The battery controller according to claim 1, wherein:
the reference value setting unit sets a median voltage value of battery cells except a battery cell having a minimum voltage, within a battery group as the reference value.

5. The battery controller according to claim 1, further comprising:
a temperature measuring unit that measures a temperature of each of the plurality of voltage measuring units; and
a reference value changing unit that changes the reference value based upon the temperature measured by the temperature measuring unit.

6. The battery controller according to claim 1, further comprising:
a stop time measuring unit that measures a time during which a vehicle mounted with the assembled battery is stopped; and
a reference value changing unit that changes the reference value based upon the stop time measured by the stop time measuring unit.

7. The battery controller according to claim 1, further comprising:
a typical value calculating unit that calculates an average value or a median value of voltages of the battery cells as a typical value for each of the plurality of battery groups based upon the voltage of each of the battery cells measured by the corresponding voltage measuring unit;
a typical reference value calculating unit that calculates an average value or a median value of typical values of the battery groups calculated by the typical value calculating unit as a typical reference value used to determine an abnormality in the voltage measuring units; and
a second abnormality determining unit that makes a determination, for each of the plurality of battery groups, that an abnormality is present in a voltage measuring unit, if a difference between the typical value and the typical reference value exceeds a predetermined value.

8. The battery controller according to claim 1, further comprising:
a first control unit; and
a second control unit connected to the first control unit through a communication line, wherein:
the first control unit includes the plurality of voltage measuring units; and
the second control unit includes the minimum value detecting unit, the reference value setting unit and the abnormality determining unit and configured to receive voltages of the plurality of battery cells measured by the plurality of voltage measuring units of the first control unit.

9. The battery controller according to claim 8, wherein:
the reference value setting unit sets a maximum voltage of the battery cells within a battery group as the reference value.

10. The battery controller according to claim 8, wherein:
the reference value setting unit sets an average voltage of the battery cells except a battery cell having a minimum voltage, within a battery group as the reference value.

11. The battery controller according to claim 8, wherein:
the reference value setting unit sets a median voltage value of the battery cells except a battery cell having a minimum voltage, within a battery group as the reference value.

12. The battery controller according to claim 8, wherein
the second control unit includes:
a temperature measuring unit that measures a temperature of each of the plurality of voltage measuring units; and
a reference value changing unit that changes the reference value based upon the temperature measured by the temperature measuring unit.

13. A method for detecting an abnormal voltage in an assembled battery configured by connecting a plurality of battery groups each including a plurality of battery cells, comprising:
a voltage measuring step of measuring a voltage of each of the battery cells included in each of the plurality of battery groups;
a minimum value detecting step of detecting a minimum value of the battery cells for each of the plurality of battery groups based upon the voltage of each of the battery cells measured in the voltage measuring step;
a reference value setting step of setting a reference value used to determine an abnormal voltage drop for each of the plurality of battery groups based upon the voltage of each of the battery cells measured in the voltage measuring step; and
an abnormality determining step of making a determination that an abnormal voltage drop is present, if a difference between the reference value and the minimum value exceeds a predetermined value, for each of the plurality of battery groups.

14. The method for detecting an abnormal voltage in an assembled battery according to claim 13, wherein:
a first control unit of the assembled battery executes the voltage measuring step; and
a second control unit connected to the first control unit of the assembled battery through a communication line receives voltages of the plurality of battery cells measured by the voltage measuring step of the first control unit and executes the minimum value detecting step, the reference value setting step and the abnormality determining step.
